# EUROPEAN PATENT APPLICATION

(11) **EP 4 498 424 A1**
(43) Date of publication of application: **29.01.2025**
(21) Application number: 24188556.5
(22) Date of filing: 15.07.2024
(51) Int. Cl.: H01L 21/8258, H01L 21/02, H01L 27/06, H01L 27/085

(54) **MANUFACTURING PROCESS OF A SEMICONDUCTOR ELECTRONIC DEVICE INTEGRATING DIFFERENT ELECTRONIC COMPONENTS AND SEMICONDUCTOR ELECTRONIC DEVICE**

(30) Priority: 27.07.2023 IT 202300015885
(71) Applicant: STMicroelectronics International N.V., 1228 Plan-les-Ouates, Geneva (CH)
(72) Inventor: DEPETRO, Riccardo, 28845 DOMODOSSOLA (VB) (IT)
(74) Representative: Studio Torta S.p.A.

(57) **Abstract**

For manufacturing a semiconductor electronic device (1) a wafer (100) is provided which has a substrate layer (18) of semiconductor material having a first portion (101A) and a second portion (101B) distinct from the first portion. An epitaxial region (23, 106) of a single semiconductor material is grown on the first portion (101A) of the substrate layer. An epitaxial multilayer (49, 114) having a heterostructure (50) is grown on the second portion (101B) of the substrate layer. A first electronic component (5A, 5B, 5C, 5D) based on the single semiconductor material is formed from the epitaxial region (23, 106) and a second electronic component (7) based on heterostructure is formed from the heterostructure. Forming a first electronic component comprises forming a plurality of doped regions (25A, 25B, 27, 29A, 29B, 31) in the epitaxial region (23), after the step of growing an epitaxial multilayer.

## Description

### Technical Field

The present invention relates to a manufacturing process of a semiconductor electronic device integrating different electronic components and to a semiconductor electronic device.

### Background

Semiconductor electronic devices are known which comprise active and/or passive electronic components based on silicon, for example CMOS, DMOS, BJT transistors, diodes, resistors, etc., integrated in a same silicon die and made for example using BCD (Bipolar-CMOS-DMOS) technology.

In practice, the functioning of these electronic components is based on the electronic properties of a single semiconductor material (silicon).

These devices monolithically integrate, in the same die, digital circuits, analog circuits and power circuits that work at very different voltages one from the other, for example from a few volts in the case of CMOS transistors used for the implementation of logic functions up to hundreds of volts in the case of DMOS transistors used for power applications.

The electronic components based on silicon are integrated into a monocrystalline silicon region grown on a <100> silicon wafer.

Also known are semiconductor electronic devices comprising electronic components based on heterostructure, for example HEMT transistors.

In practice, the operation of these electronic components is based on the electronic properties of a heterojunction between two different semiconductor materials.

In detail, in HEMT transistors, the conductive channel is based on the formation of layers of two-dimensional electron gas (2DEG) with high mobility which form at a heterojunction, i.e. at the interface between semiconductor materials having different band gap. For example, HEMT devices are known based on the heterojunction between an aluminum gallium nitride (AlGaN) layer and a gallium nitride (GaN) layer.

HEMT devices, in particular based on AlGaN/GaN heterostructures or heterojunctions, offer various advantages that make them particularly suitable and widely used for different applications. For example, the high breakdown threshold of HEMT devices is exploited for high-performance power switches; the high mobility of the electrons in the conductive channel allows high-frequency amplifiers to be formed; furthermore, the high concentration of electrons in the 2DEG allows a low ON-state resistance (R_{ON}) to be obtained.

Furthermore, HEMT devices for radio frequency (RF) applications typically have better RF performances than similar silicon LDMOS devices.

The electronic components based on heterostructure are integrated into a heterostructure grown epitaxially on a <111> silicon wafer, or on a sapphire (Al₂O₃) or silicon carbide (SiC) substrate.

In order to use a simple and low-cost manufacturing process, the heterostructure-based electronic components and the silicon-based electronic components are integrated in different dice one from the other, starting from two different silicon wafers. In this manner, the manufacturing process of the silicon-based components and that of the heterostructure-based components do not influence each other.

For example, the heterostructure may be grown using a high thermal budget, without damaging components based on silicon.

However, this causes an electronic apparatus that incorporates both components based on silicon and components based on heterostructure to have a high area occupation and therefore a high manufacturing cost, high power consumption and low electrical performances, for example due to the parasitic capacitances, resistances or inductances introduced by the electrical connections between dice.

According to one approach, the die having the silicon-based components formed therein and the die having the heterostructure-based components formed therein are bonded on each other through a die transfer technology.

However, even this approach has disadvantages in terms of costs and manufacture and electrical performance reliability, in use.

### Summary

According to the present invention a manufacturing process of a semiconductor electronic device and a semiconductor electronic device are thus provided, as defined in the attached claims.

### Brief Description of the Drawings

For a better understanding of the present invention, embodiments thereof are now described, purely by way of nonlimiting example, with reference to the attached drawings, wherein:
- Figure 1 shows a cross-section of a semiconductor electronic device, according to an embodiment;
- Figure 2 shows a top-plan view of the device of Figure 1; and
- Figures 3A-3N show cross-sections of the device of Figure 1 in subsequent manufacturing steps.

### Description of Embodiments

The following description refers to the arrangement shown in the accompanying Figures; consequently, expressions such as "above", "below", "lower", "upper", "right", "left", "high", "low", and the like, relate to the accompanying Figures and should not be interpreted in a limiting manner.

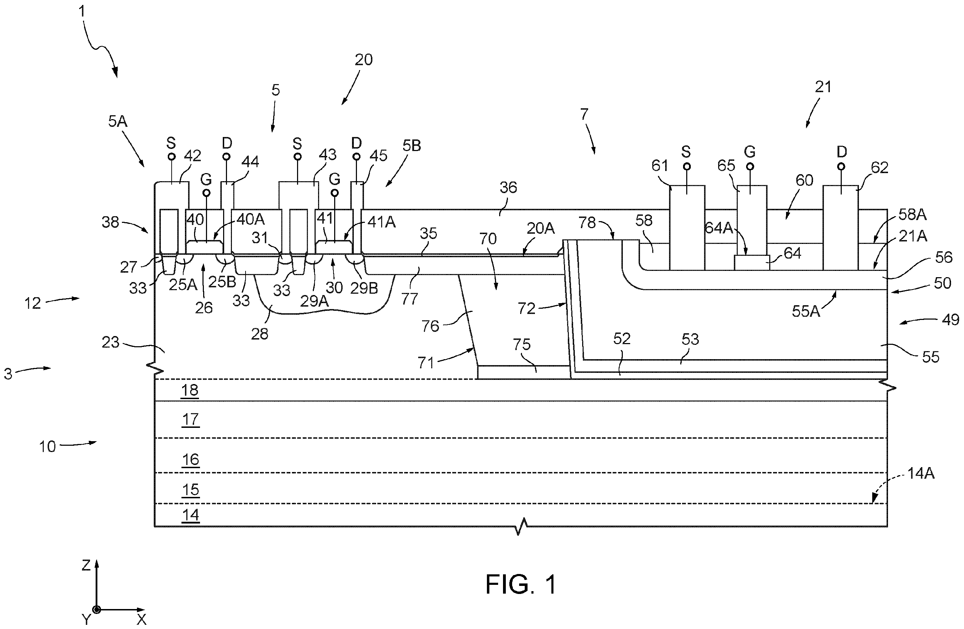

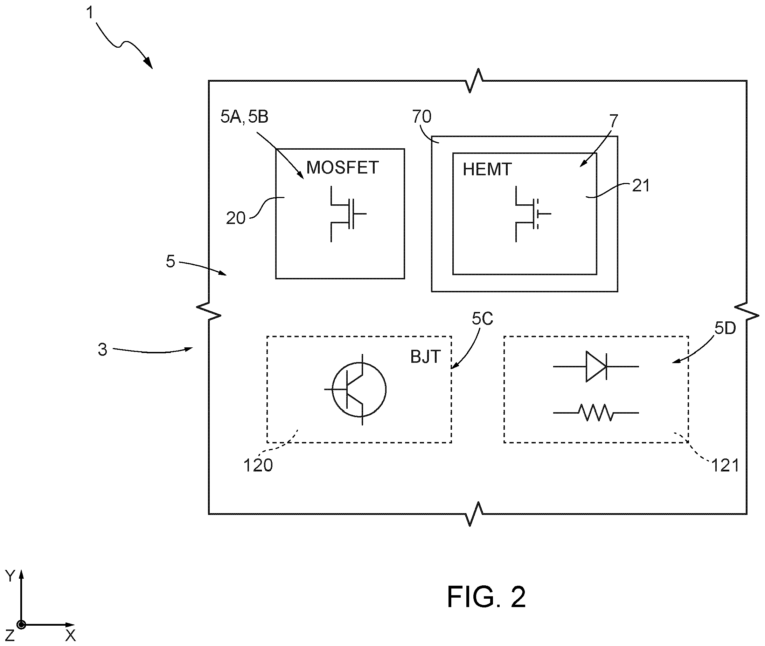

Figures 1 and 2 show a semiconductor electronic device (hereinafter simply referred to as device) 1, in a Cartesian reference system XYZ having a first axis X, a second axis Y and a third axis Z.

The device 1 is formed in a die 3 and comprises one or more silicon-based electronic components 5, of which a PMOS transistor 5A and a NMOS transistor 5B are shown in Figure 1, and one or more heterostructure-based electronic components, of which a HEMT transistor 7 is shown in Figure 1, all integrated into the die 3.

The die 3 comprises a substrate region 10 and a surface region 12 which extends on, in particular in direct contact with, the substrate region 10.

The substrate region 10 comprises a substrate 14 and one or more epitaxial layers arranged on the substrate 14.

The substrate 14 is of semiconductor material, in particular monocrystalline material, and has an upper surface 14A.

In detail, in this embodiment, the substrate 14 is of monocrystalline silicon that is oriented, in particular the upper surface 14A is oriented, according to the <111> crystallographic direction.

In this embodiment, the substrate region 10 comprises a first epitaxial layer, or first deep layer 15, overlying the upper surface 14A of the substrate 14; a second epitaxial layer, or first intermediate layer 16, overlying the first deep layer 15; a third epitaxial layer, or second deep layer 17, overlying the first intermediate layer 16; and a fourth epitaxial layer, or second intermediate layer 18, overlying the second intermediate layer 17.

The epitaxial layers 15-18 are of semiconductor material, in particular equal to that of the substrate 14 (here of silicon), and are identified for the sake of clarity by dashed lines in Figure 1.

The thickness along the third axis Z, the conductivity type (for example, P or N) and the doping profile of the substrate 14 and of the epitaxial layers 15-18 may be chosen, in the design step, according to the specific application of the device 1.

For example, the epitaxial layers 15-18 may each have a thickness comprised between 0.1 µm and 7 µm.

For example, in this embodiment, the substrate 14 is of P-type, for example with a resistivity comprised between 0.1 Ω·cm and 20 Ω·cm, and the epitaxial layers 15-18 are of N-type. In this manner, the first deep layer 15 may create a PN junction with the substrate 14 which, in use, may be used to insulate the devices 5, 7 integrated in the die 3 from the substrate 14.

The first and the second deep layers 15, 17 may have a doping level equal to or different from, in particular higher than, the first and the second intermediate layers 16, 18. For example, the doping level of the first and the second deep layers 15, 17 may be comprised between 0.1 Ω·cm and 20 Ω·cm and the doping level of the first and the second intermediate layers 16, 18 may be comprised between 0.1 Ω·cm and 20 Ω·cm.

A high doping level of the first deep layer 15 causes, in use, the depleted region between first deep layer 15 and substrate 14 to extend mainly into the substrate 14, thus improving the electrical insulation of the components 5,7 from the substrate 14.

Furthermore, the high doping level of the first deep layer 15 may allow, in use, the first deep layer 15 to be used as current conduction region of the electronic components integrated into the die 3, for example if the silicon-based components 5 include BJT transistors.

The presence of both the first and the second deep layers 15, 17 may be useful to simplify the manufacture of the device 1 and to obtain, in use, excellent electrical performances of the device 1, in case the electronic components 5, 7 are designed to operate at high voltages with respect to the substrate 14, for example to operate correctly with a voltage of 5 V applied to the respective ends referred to positive voltages from about 20 V, for example 60 V, 100 V or 650 V, with respect to the substrate 14, according to the specific application and to the doping type used.

The surface region 12 extends on the second intermediate layer 18, in particular in direct contact therewith, and comprises a first device portion 20, wherein the PMOS transistor 5A and NMOS transistor 5B are integrated, and a second device portion 21, wherein the HEMT transistor 7 is integrated.

The first device portion 20 has an upper surface 20A and comprises an epitaxial region 23 of semiconductor material, in particular of the same material as the second intermediate layer 18, here monocrystalline silicon.

The epitaxial region 23 extends from the second intermediate layer 18, in particular here in direct contact therewith, up to the upper surface 20A.

The thickness along the third axis Z, the conductivity type (for example, P or N) and the doping profile of the epitaxial region 23 may be chosen, in the design step, according to the specific application of the device 1.

For example, in this embodiment, the epitaxial region 23 is of N-type.

The first device portion 20 comprises a plurality of doped regions which extend within the epitaxial region 23 and form functional regions of the silicon-based electronic components 5.

In detail, in the embodiment of Figure 1, doped regions 25A, 25B of P++ type extend within the epitaxial region 23 from the upper surface 20A. The doped regions 25A, 25B form the source region and, respectively, the drain region of the PMOS transistor 5A and delimit a channel region 26 of the PMOS transistor 5A.

Furthermore, a doped region 27 of N++ type extends in the epitaxial region 23 from the upper surface 20A and forms a body contact region of the PMOS transistor 5A.

Still with reference to the embodiment of Figure 1, a doped region 28 of P-type extends in the epitaxial region 23 from the upper surface 20A and forms the body region of the NMOS transistor 5B.

Doped regions 29A, 29B of N++ type extend within the doped region 28 and form the source region and, respectively, the drain region of the NMOS transistor 5B, and delimit a channel region 30 of the NMOS transistor 5B.

Furthermore, a doped region 31 of P++ type extends within the doped region 28 and forms a body contact region of the NMOS transistor 5B.

In practice, the doped regions 25A, 25B, 27, 29A, 29B and 31, i.e. the source and drain doped regions and the body contact regions, are highly doped regions, with a doping level comprised for example between 5·10¹⁹ atoms/cm⁻³ and 5·10²⁰ atoms/cm⁻³ as peak concentration. Conversely, the doped region 28, i.e. the body region, is a low-doping region, with a doping level comprised for example between 1·10¹⁶ atoms/cm⁻³ and 2·10¹⁸ atoms/cm⁻³ as a peak concentration.

Number, arrangement, shape, size and doping profile of the doped regions may be chosen, in the design step, according to the specific silicon-based electronic components 5 integrated in the die 3 and to the specific application of the device 1.

Insulating portions 33 of insulating material, for example of oxide, may extend, according to the specific application, within the epitaxial region 23 from the upper surface 20A.

In particular, in Figure 1, the insulating portions 33 extend, parallel to the first axis X, between the doped regions 27 and 25A, 25B and 31, 31 and 29A.

A first insulating layer 35, for example of oxide or nitride, extends on the upper surface 20A of the first device portion 20.

A second insulating layer 36, for example of oxide, extends on the first insulating layer 35.

Surface structures 38 of the silicon-based components 5, extend on the upper surface 20A of the first device region 20, in direct contact therewith. The surface structures 38 form further functional regions of the silicon-based devices 5 and may include various conductive and/or insulating regions, according to the specific silicon-based electronic components 5 integrated in the die 3.

In this embodiment, the surface structures 38 comprise gate insulated regions 40, 41 which respectively extend over the channel region 26 of the PMOS transistor 5A and over the channel region 30 of the NMOS transistor 5B. Of the gate insulated regions 40, 41, for the sake of simplicity, only the respective conductive regions, here of polysilicon and again indicated by 40, 41, each having a respective upper surface 40A, 41A, are shown in Figure 1.

Even if not shown in Figure 1, the gate insulated regions 40, 41 may each also comprise a respective insulating region arranged between the respective polysilicon region and the upper surface 20A and a respective contact region of conductive material, for example a metal, in contact with the respective surface 40A, 41A and forming a respective gate terminal G.

In the embodiment of Figure 1, the surface structures 38 also comprise source contact regions 42, 43 and drain contact regions 44, 45, of conductive material, which extend through the first and the second insulating layers 35, 36, in direct contact with the upper surface 20A, forming respective source S and drain D terminals.

In detail, the source contact regions 42, 43 extend in direct contact with the source region 25A of the PMOS transistor 5A and, respectively, the source region 29A of the NMOS transistor 5B.

Furthermore, in the embodiment shown, the source contact regions 42, 43 each extend in direct contact also with the respective body contact region 27, 31.

The drain contact regions 44, 45 extend in direct contact with the drain region 25B of the PMOS transistor 5A and, respectively, the drain region 29B of the NMOS transistor 5B.

The second device portion 21 of the surface region 12 has an upper surface 21A and comprises an epitaxial multilayer 49 extending on the second intermediate layer 18 and grown therefrom.

The epitaxial multilayer 49 comprises a heterostructure 50 wherein the HEMT transistor 7 is integrated.

In the embodiment of Figure 1, the epitaxial multilayer 49 also comprises a transition region formed here by a first and a second buffer layer 52, 53 superimposed on each other, which are arranged between the second intermediate layer 18 and the heterostructure 50. The transition region may be useful during the manufacture of the device 1 to favor the epitaxial growth of the heterostructure 50 on the second intermediate layer 18.

In detail, the first buffer layer 52, for example of aluminum nitride (AlN), extends on and in direct contact with the second intermediate layer 18, and the second buffer layer 53, for example of aluminum gallium nitride (AlGaN), extends on and in direct contact with the first buffer layer 52.

The heterostructure 50 comprises compound semiconductor materials including elements of groups III and V of the periodic table and forms the upper surface 21A of the second device portion 21.

The upper surface 21A of the second device portion 21 may extend at a coordinate along the third axis Z equal to or different from that of the upper surface 20A of the first device portion 20, according to the specific manufacturing steps used for manufacturing the device 1.

In particular, in this embodiment, the upper surface 21A of the second device portion 21 is arranged at a lower height, measured along the third axis Z, with respect to the upper surface 20A of the first device portion 20. This may allow the manufacture of the device 1 to be improved.

The heterostructure 50 comprises a channel layer 55 and a barrier layer 56 overlying one another.

The channel layer 55 is of a first semiconductor material, for example gallium nitride (GaN) or an alloy comprising gallium nitride such as InGaN, here of gallium nitride (GaN), extends on the transition region, in particular on the second buffer layer 53 and has an upper surface 55A.

The barrier layer 56 is of a second semiconductor material, for example a compound based on a ternary or quaternary alloy of gallium nitride, such as AlₓGa₁₋ₓN, AlInGaN, InₓGa₁₋ₓN, AlₓIn₁₋ₓAl, AlScN, here of aluminum gallium nitride (AlGaN), extending between the upper surface 55A of the channel layer 55 and the upper surface 21A of the second device portion 21.

The channel layer 55 and the barrier layer 56 may be of intrinsic, P or N type, according to the specific application; in particular, both the channel layer 55 and the barrier layer 56 may be of N-type.

For example, when the barrier layer 56 is of AlGaN, the presence of aluminum atoms may cause the barrier layer 56 to be of N-type.

The heterostructure 50 is configured to accommodate a two-dimensional gas (2DEG) of (mobile) charge carriers, in particular here of electrons, which is arranged at the interface between the channel layer 55 and the barrier layer 56, i.e. at the upper surface 55A of the channel layer 55.

An insulating layer 58 having an upper surface 58A, for example of an oxide such as for example silicon oxide, extends on the upper surface 21A.

The insulating layer 36 also extends on the second device portion 21, in particular on the insulating layer 58. The insulating layer 58 may have a thickness comprised, for example, between 20 nm and 1 µm.

Surface structures 60 of the heterostructure-based components 7 extend on the upper surface 21A of the second device portion 21.

The surface structures 60 may be various conductive and/or insulating regions, according to the specific heterostructure-based electronic components 7 integrated in the die 3, which form functional regions of the heterostructure-based components 7.

In this embodiment, wherein the heterostructure-based electronic component 7 is a HEMT transistor, the surface structures 60 comprise a source region 61 and a drain region 62, of conductive material, extending at a distance from each other along the first axis X.

The source region 61 and the drain region 62 are in electrical contact, in particular ohmic contact, with the heterostructure 50, in particular with the two-dimensional gas forming at the interface between the channel layer 55 and the barrier layer 56, and form a source terminal S and, respectively, a drain terminal D of the HEMT transistor 7.

In the embodiment of Figure 1, the source and drain regions 61, 62 extend, parallel to the third axis Z, through the insulating layers 36, 58 up to the upper surface 21A.

However, the source and drain regions 61, 62 may extend, parallel to the third axis Z, also partially through the heterostructure 50, for example for part of the barrier layer 56 or throughout the thickness of the barrier layer 56 up to the surface 55A, according to the specific application.

The surface structures 60 also comprise a gate structure, herein formed by a channel modulation region 64 and a gate contact region 65, which may be biased to electrically control the formation of the two-dimensional gas in the heterostructure 50 between the source region 61 and the drain region 62. The gate structure forms a gate terminal G of the HEMT transistor 7.

In this embodiment, the HEMT transistor 7 is of normally-off type, i.e. of the enhancement-type.

In detail, in this embodiment, the channel modulation region 64 is of semiconductor material and has a different conductivity type with respect to the barrier layer 56, for example of P-type. In particular, the channel modulation region 64 may be of P-type gallium nitride (p-GaN).

However, the channel modulation region 64 may be formed by a set of different materials which include dielectric layers, metal layers, and/or semiconductor layers used as control electrodes with a suitable work function.

The channel modulation region 64 extends on the upper surface 21A, between the source region 61 and the drain region 62 along the first axis X, and has an upper surface 64A.

The upper surface 64A of the channel modulation region 64 may extend at a coordinate along the third axis Z equal to or different from that of the upper surface 40A, 41A of the gate insulated regions 40, 41, according to the specific manufacturing steps used for manufacturing the device 1.

In particular, in this embodiment, the upper surface 64A of the channel modulation region 64 is arranged at a distance from the second intermediate layer 18, measured along the third axis Z, smaller with respect to the distance, measured along the third axis Z, of the upper surface 40A, 41A of the gate insulated regions 40, 41 from the second intermediate layer 18. This may allow the reliability of the manufacture of the device 1 to be increased.

The gate contact region 65, of conductive material, extends in electrical contact with the channel modulation region 64, in particular here in contact with the upper surface 64A.

The surface region 12 of the die 3 also comprises a residual separation portion 70 which extends on the second intermediate layer 18, in direct contact therewith, between the first and the second device portions 20, 21.

As visible in the schematic top-view of Figure 2, the residual separation portion 70 surrounds the second device portion 21.

Again with reference to Figure 1, the residual separation portion 70 has an upper surface which, in this embodiment, is continuous with, in particular aligned with, the upper surface 20A of the first device portion 20 and consequently is indicated with the same reference number.

The residual separation portion 70 is laterally contiguous, parallel to the first axis X, to the second device portion 21.

In detail, the residual separation portion 70 has a first side wall 71 contiguous to the first device portion 20 and a second side wall 72 opposite to the first side wall 71 and contiguous to the second device portion 21.

The residual separation portion 70 comprises a definition region 75, for example comprising an oxide, in particular silicon oxide, which extends on, and in direct contact with, the second intermediate layer 18; and a polycrystalline region 76, of the same material (silicon) as the epitaxial region 23 of the first device portion 20, which extends on, and in direct contact with, the definition region 75.

The definition region 75 may be formed by a single layer, for example of oxide, in particular silicon oxide, or by a multilayer comprising for example one or more layers of an oxide and/or one or more layers of a nitride.

In detail, according to one embodiment, the definition region 75 may be of silicon oxide.

According to a different embodiment, the definition region 75 may comprise an oxide layer, in particular silicon oxide, and a nitride layer. According to one embodiment, the oxide layer may be in direct contact with the semiconductor layer 18.

The definition region 75 may have a thickness along the third axis Z, comprised for example between 7 nm and 300 nm, in particular between 70 Å and 200 Å.

In this embodiment, the polycrystalline region 76 has a polycrystalline structure.

In this embodiment, the polycrystalline region 76 is monolithic with the epitaxial region 23.

The tilting of the first side wall 71 may depend on the crystalline orientation of the epitaxial region 23 and on the thickness along the third axis Z of the definition region 75. For example, in case the epitaxial region 23 is oriented according to the <111> crystallographic direction, the first side wall 71 may form an angle of about 54° with a direction parallel to the first axis X.

The polycrystalline region 76 extends at a distance from the upper surface 20A.

An insulation region 77 of insulating material, for example of oxide, extends in the die 3, from the upper surface 20A, between the first and the second device portions 20, 21.

In detail, the insulation region 77 extends, parallel to the third axis Z, in the first device portion 20 from the upper surface 20A within the epitaxial region 23 and, in the residual separation portion 70, between the upper surface 20A and the polycrystalline region 76.

In the embodiment of Figure 1, the epitaxial multilayer 49 comprises a portion which extends, in a conformal manner, on the second side wall 72 of the residual separation portion 70 forming a raised surface 78.

The raised surface 78 is arranged at a coordinate along the third axis Z greater with respect to the upper surface 21A and, here, even greater than the upper surface 58A of the insulating layer 58.

Shape and structure of the residual separation portion 70 may vary according to the specific manufacturing steps used for manufacturing the device 1.

The presence of a polycrystalline region (region 76) between the epitaxial multilayer (21) and the epitaxial region (23) may be useful to reduce the stress caused by the lattice mismatch between the materials that form the epitaxial multilayer (e.g. GaN) and the material that forms the epitaxial region (e.g. silicon). Consequently, the presence of the polycrystalline region may contribute to the reduction of the risk of dislocations in the die 3 (and therefore possible breaking of the device 1).

The device 1 allows the functionality of the silicon-based components 5 and the heterostructure-based components 7 to be combined, in a single die, while maintaining small dimensions with respect to an electronic device wherein the silicon-based components 5 and the heterostructure-based components 7 are integrated in different dice.

Furthermore, the electrical connection between the silicon-based components 5 and the heterostructure-based components 7 may be formed directly on the die 3. This may ensure high electrical performances, in use, of the device 1; for example, in terms of switching speed of the various components, minimum resistive losses relating to electrical connections therebetween, and minimum overvoltage effects due to the presence of parasitic inductances.

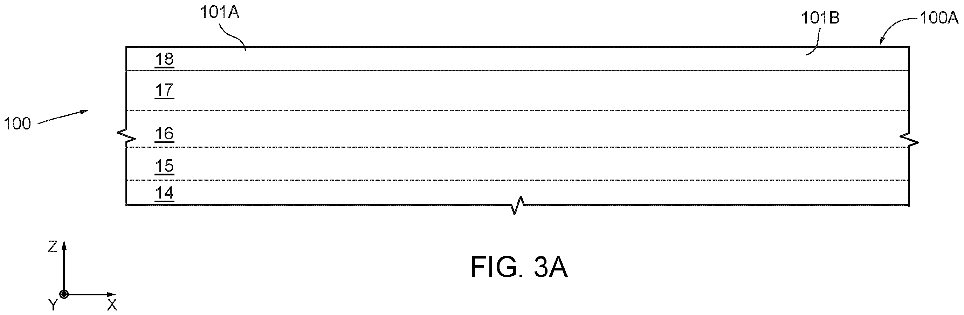

Hereinafter, with reference to Figures 3A-3N, manufacturing steps of the semiconductor electronic device 1 are described.

Figure 3A shows a cross-section of a wafer 100 of monocrystalline semiconductor material, in particular silicon, having an upper surface 100A. Elements of the wafer 100 common to what has already been described with reference to Figure 1 are indicated with the same reference numbers and are not further described in detail.

The wafer 100 comprises the substrate 14 having the epitaxial layers 15, 16, 17, and 18 already grown thereon.

The fourth epitaxial layer, or second intermediate layer, 18 forms the upper surface 100A of the wafer 100.

The second intermediate layer 18 comprises a first portion 101A whereon the first device portion 20 is intended to be formed, i.e. wherein the PMOS 5A and NMOS 5B transistors are intended to be integrated; and a second portion 101B whereon the second device portion 21 is intended to be formed, i.e. whereon the epitaxial multilayer 49 is intended to be grown and the HEMT transistor 7 integrated.

The first portion 101A is arranged laterally to the second portion 101B, in particular laterally along the first axis X in the shown embodiment.

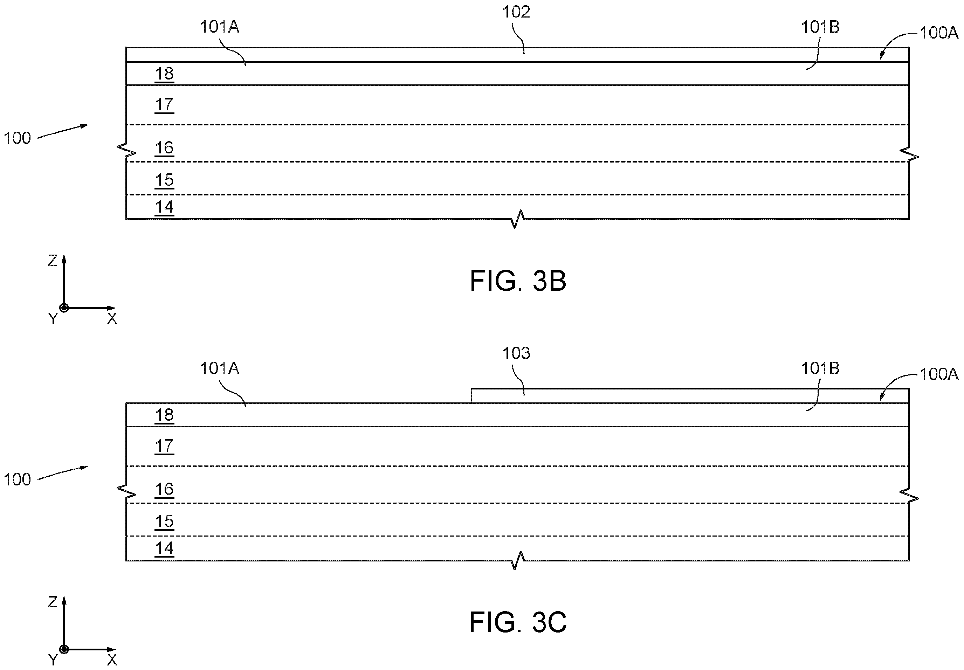

Subsequently, Figure 3B, a definition layer 102, for example comprising an oxide, in particular of silicon oxide, is formed on the upper surface 100A.

The definition layer 102 may be formed by one or more layers of different material, as discussed for the definition region 75 of Figure 1.

The definition layer 102 may have a thin thickness along the third axis Z, comprised for example between 7 nm and 300 nm, in particular between 70 Å and 200 Å.

The definition layer 102 is intended to form the definition region 75 (Figure 1).

The definition layer 102 may be formed by oxidation of a surface portion of the second intermediate layer 18, or by deposition on the upper surface 100A. In case of oxidation, the thickness of the second intermediate layer 18 may reduce in response to the oxidation with respect to the layer 18 of Figure 3A. However, given the much smaller thickness of the definition layer 102 with respect to the thickness of the second intermediate layer 18, it may be assumed for the sake of simplicity that the thickness of the second intermediate layer 18 remains, as a first approximation, the same before and after the oxidation.

Then, Figure 3C, the definition layer 102 is removed at the first portion 101A of the second intermediate layer 18, (whereon the first device portion 20 is intended to be formed), i.e. the portion of the second intermediate layer 18 whereon the epitaxial region 23 is intended to be formed. Therefore, of the definition layer 102 a portion, hereinafter also referred to as growth mask 103, remains.

In practice, the growth mask 103 exposes the first portion 101A of the second intermediate layer 18 and covers the second portion 101B of the second intermediate layer 18.

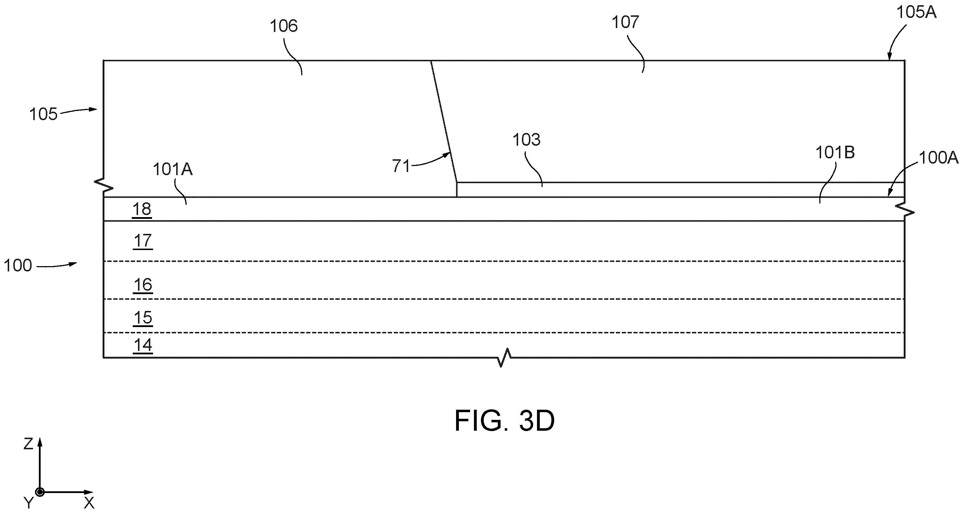

In Figure 3D, a surface layer 105 of semiconductor material, in particular of the same material as the second intermediate layer 18 (here silicon), is grown on the wafer 100.

The surface layer 105 has an upper surface 105A.

The surface layer 105 comprises an epitaxial portion 106 which grows parallel to the third axis Z from the second intermediate layer 18, in particular from the respective first portion 101A, and a sacrificial portion 107 which grows parallel to the third axis Z on the growth mask 103.

The epitaxial portion 106, which grows from a monocrystalline substrate, maintains the monocrystalline structure of the second intermediate layer 18 and is intended to form the epitaxial region 23 of the first device portion 20.

The sacrificial portion 107, which grows from a non-crystalline substrate, has a polycrystalline structure.

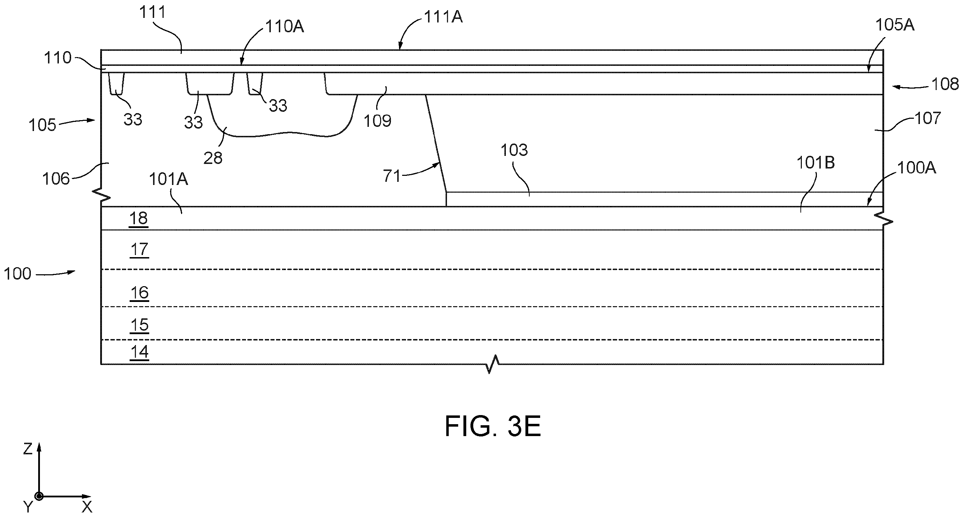

In Figure 3E, the doped region 28, corresponding to the body region of the NMOS transistor 5B, and, optionally, an insulating layer 108 are formed in the surface layer 105.

In detail, the body region 28 is formed in the epitaxial portion 106, where the silicon-based components 5 are formed.

The body region 28 may be formed by doping ions implantation.

The insulating layer 108, for example of silicon oxide, forms the insulating portions 33 (Figure 1) and a portion 109 intended to form the insulation region 77 (Figure 1).

The insulating layer 108 may be formed by forming insulation trenches in the surface layer 105, for example Shallow Trench Isolation (STI). In this case, the thickness of the epitaxial portion 106 and of the sacrificial portion 107 may reduce in response to the formation of the insulating layer 108.

Furthermore, again with reference to Figure 3E, one or more surface layers 110 may be formed on the upper surface 105A of the surface layer 105, according to the specific silicon-based electronic components 5 that it is desired to integrate in the die 3 of the device 1.

In the embodiment shown, the surface layers 110 are layers intended to form the gate insulated regions 40, 41 (Figure 1) of the PMOS and NMOS transistors 5A, 5B. In particular, of the surface layers 110 only a single gate layer, here of polysilicon, still indicated by 110, is shown here. However, an oxide layer, here not shown, is formed in a per se known manner between the upper surface 105A and the polysilicon layer 110.

The polysilicon layer 110 has an upper surface 110A.

A mask sacrificial layer 111, for example of insulating material, for example a single layer or an insulating multilayer comprising for example one or more of silicon oxide, silicon nitride, aluminum oxide, and silicon carbide, having an upper surface 111Ais also formed on the surface 110A of the gate layer 110.

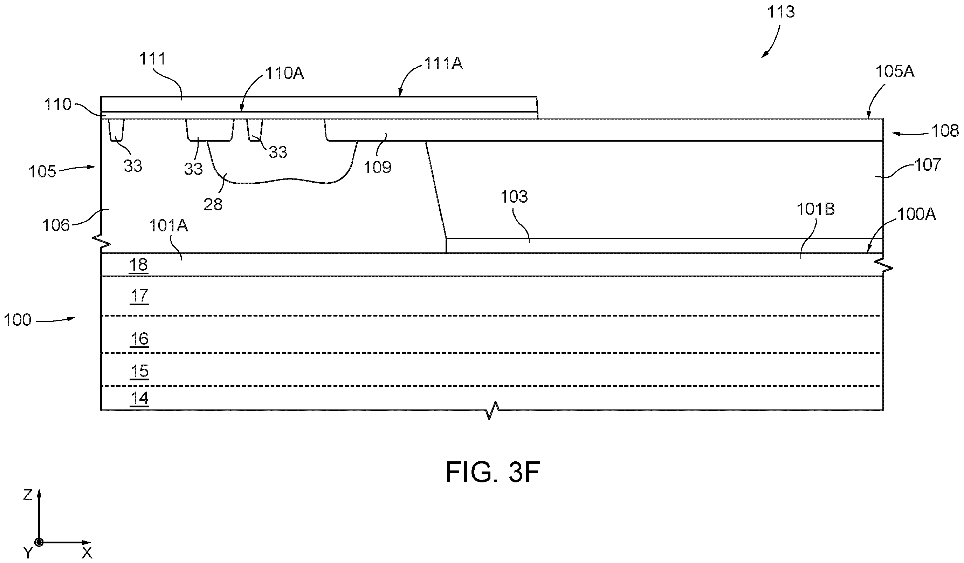

In Figure 3F, an opening 113 is opened over the sacrificial portion 107.

The opening 113 is formed by selectively removing part of the layers 110, 111, thereby exposing the underlying sacrificial portion 107.

The remaining portion of the sacrificial layer 111 may be used as an etching mask.

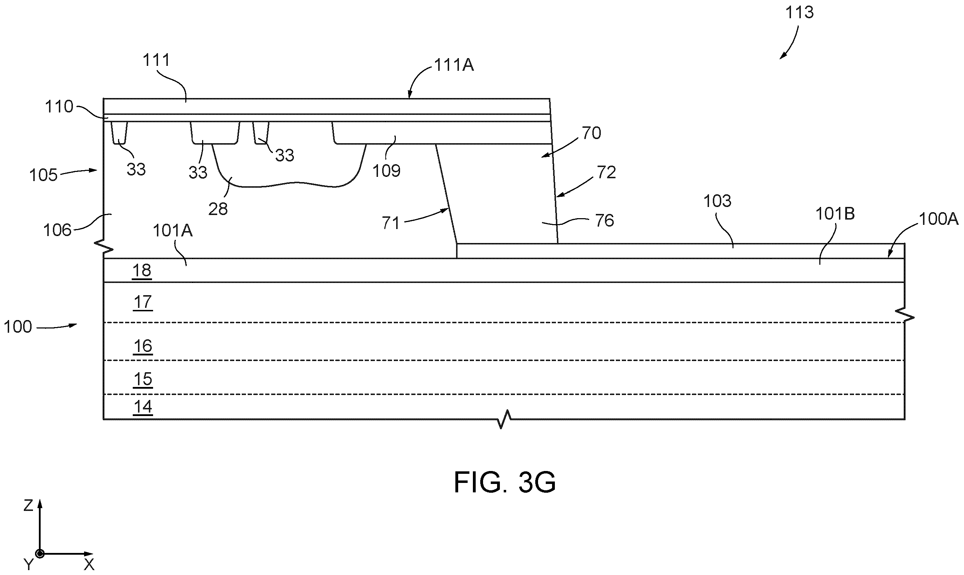

Subsequently, Figure 3G, the insulating layer 108 and the sacrificial portion 107 are removed at the opening 113, using the etching mask 111.

Therefore, of the sacrificial portion 107, the portion arranged below the etching mask remains, which will form the polycrystalline region 76 of Figure 1.

Following upon the etching of Figure 3G, the recess formed in the sacrificial portion 107 is continuous with the opening 113 and exposes the part of the growth mask 103.

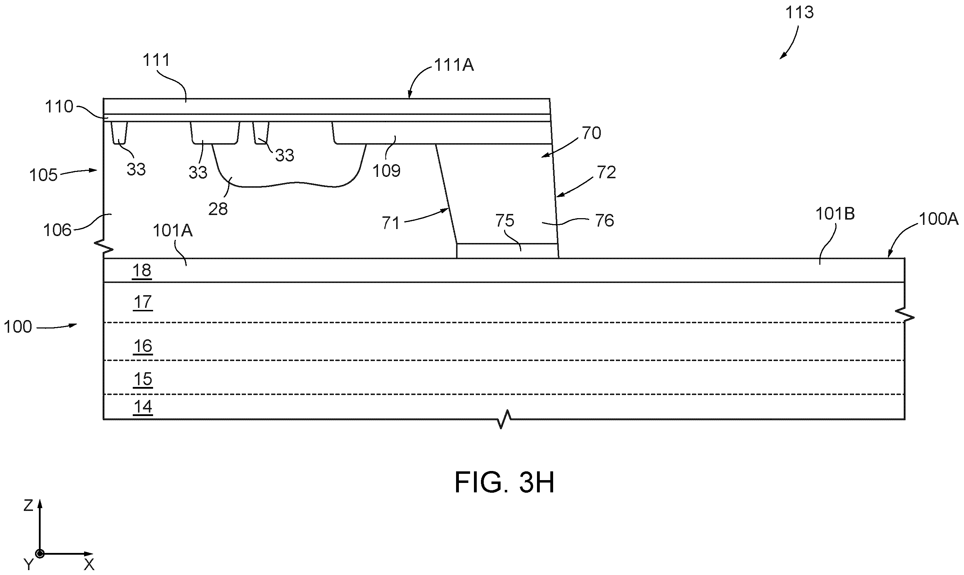

In Figure 3H, the exposed part of the growth mask 103 is removed. Therefore, of the growth mask 103, the portion arranged below the work polycrystalline region 76, i.e. the definition region 75 of Figure 1, remains.

The etching of the exposed part of the growth mask 103 may be performed using a selective chemistry which does not etch, to a first approximation, the underlying second intermediate layer 18.

Following upon the etching of Figure 3H, the opening 113 thus also exposes the second portion 101B of the second intermediate layer 18.

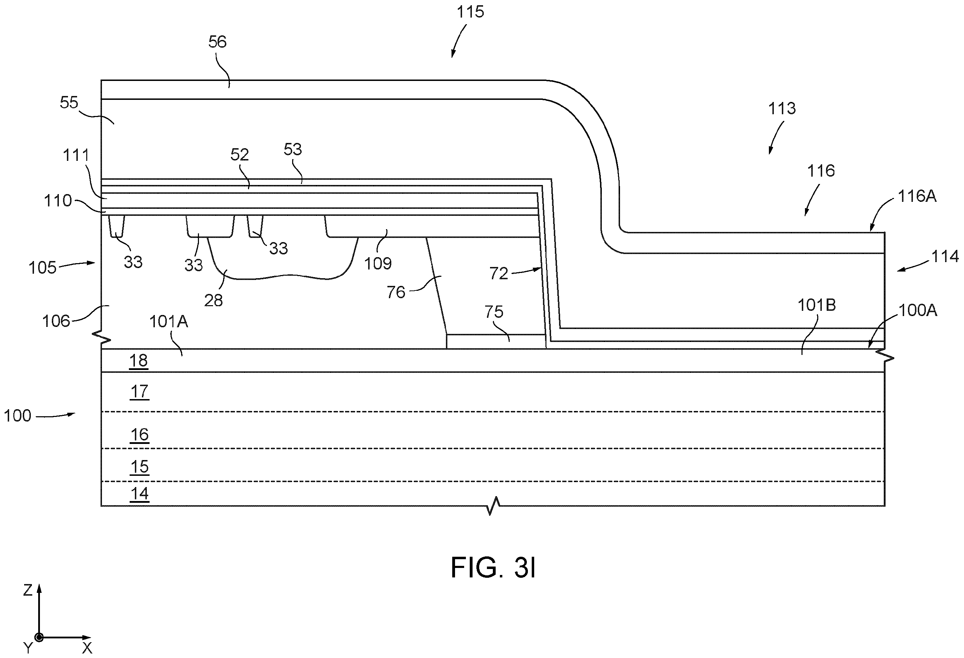

Then, Figure 3I, a work multilayer 114, which is intended to form the epitaxial multilayer 49 of Figure 1, is grown on the wafer 100.

In detail, a first buffer layer, corresponding to the buffer layer 52 of Figure 1 and thus indicated by the same reference number, is grown on the wafer 100. The first buffer layer 52 extends on the exposed portion of the upper surface 100A, on the second side wall 72 and on the etching mask 111.

A second buffer layer, corresponding to the buffer layer 53 of Figure 1 and therefore indicated by the same reference number, is grown on the first buffer layer 52.

A channel layer, corresponding to the channel layer 55 of Figure 1 and therefore indicated by the same reference number, is grown on the second buffer layer 53.

A barrier layer, corresponding to the barrier layer 56 of Figure 1 and therefore indicated by the same reference number, is grown on the channel layer 55.

The work multilayer 114 comprises an elevated portion 115, which extends on the etching mask 111 and on the second side wall 72 of the residual portion 70, and a useful portion 116 which extends directly on the upper surface 100A of the second intermediate layer 18.

The useful portion 116 has an upper surface 116A which is substantially planar, in particular substantially parallel to the upper surface 100A.

The useful portion 116, grown on the second intermediate layer 18, is of monocrystalline type and is used to integrate the heterostructure-based devices 7.

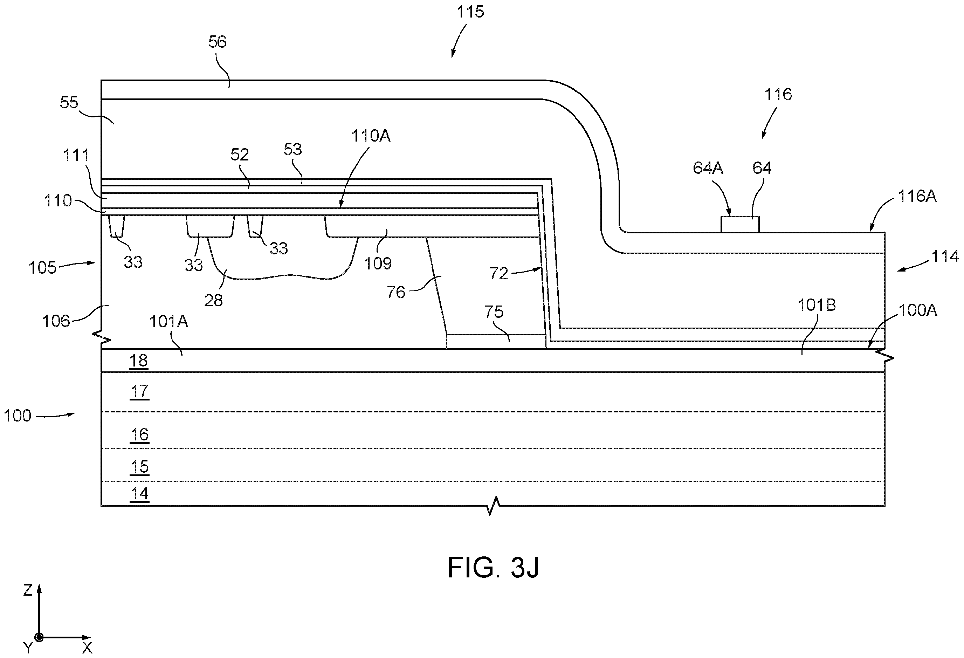

Then, Figure 3J, the channel modulation region 64 is formed, in a per se known manner, for example by growing and defining a specific layer, on the upper surface 116A of the useful portion 116.

In practice, in this embodiment, the useful portion 116 of the work multilayer 114 also comprises the channel modulation region 64.

Thus, here, the surface 64A of the modulation region 64 forms the most elevated surface of the useful portion 116, i.e. the surface of the useful portion 116 at the greatest distance along the third axis Z from the surface 100A.

The surface 110A, on which the etching mask 111 extends, may be arranged at a distance, along the third axis Z from the surface 100A, greater with respect to the most elevated surface of the useful portion 116 and lower with respect to the surface 110A. This may be useful in the subsequent manufacturing steps to protect the channel modulation region 64 and therefore increase the reliability of the manufacturing process of the device 1.

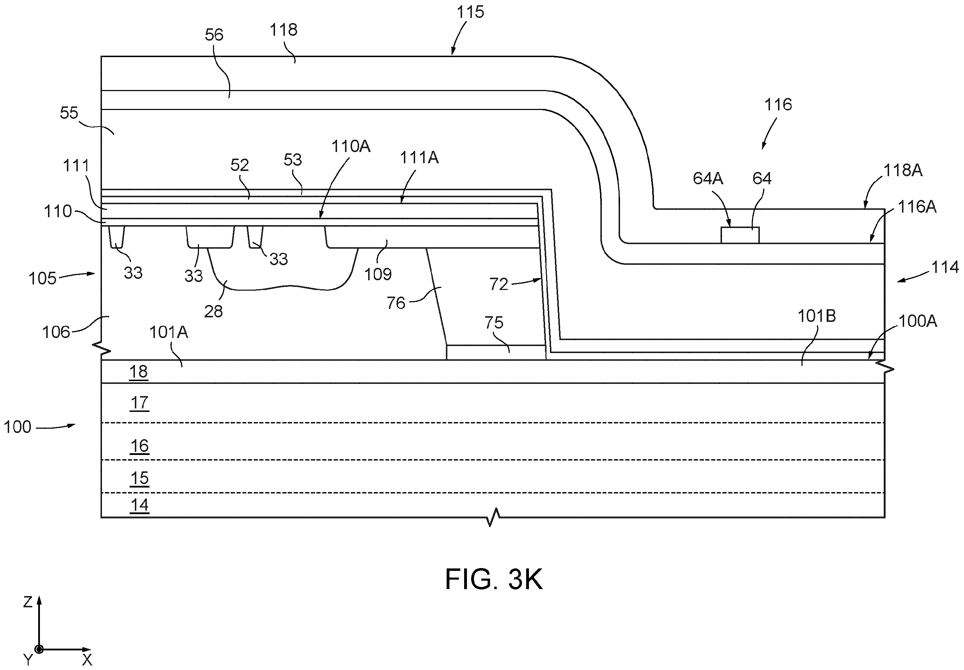

A protective layer 118 of insulating material, for example a single layer or an insulating multilayer comprising, for example, one or more of silicon oxide, silicon nitride, aluminum oxide and silicon carbide is formed, Figure 3K, on the barrier layer 56. The protective layer 118 has a thickness, along the third axis Z, for example comprised between 10 nm and 500 nm, greater than that of the channel modulation region 64.

In other words, the protective layer 118 completely covers the channel modulation region 64.

The protective layer 118 has, at the useful portion 116, an upper surface 118A which faces the upper surface 116A of the useful portion 116.

In this embodiment, the upper surface 118A of the protective layer 118 extends to a height, along the third axis Z from the surface 100A, that is lower than the height, along the third axis Z from the surface 100A, of the upper surface 111A of the etching mask 111. This may be useful in the subsequent manufacturing steps to protect the channel modulation region 64 and therefore increase the reliability of the manufacturing process of the device 1.

Furthermore, in this embodiment, the distance along the third axis Z between the upper surface 118A of the protective layer 118 and the upper surface 64A of the channel modulation region 64 is greater than the thickness, along the third axis Z, of the etching mask 111. This may be useful in the subsequent manufacturing steps to protect the channel modulation region 64 and therefore increase the reliability of the manufacturing process of the device 1.

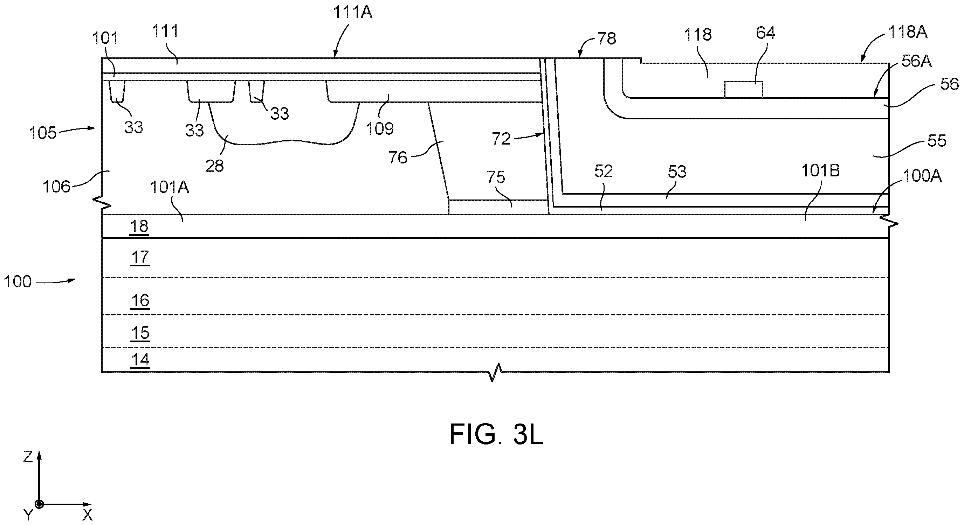

In Figure 3L, the elevated portion 115 of the work multilayer 114 is removed, at least in part, up to the upper surface 111A of the etching mask 111, thereby exposing the etching mask 111.

The removal may be performed by planarization, e.g. chemical-mechanical polishing (CMP) or other etching techniques.

In the embodiment shown, following upon the removal, of the elevated portion 115 of the work multilayer 114 only the part extending on the second side wall 72, which forms the raised portion 78, level with the upper surface 111A of the etching mask 111, remains.

Of the protective layer 118 the portion, still indicated by 118, extending on the useful portion 116 of the work multilayer 114 remains.

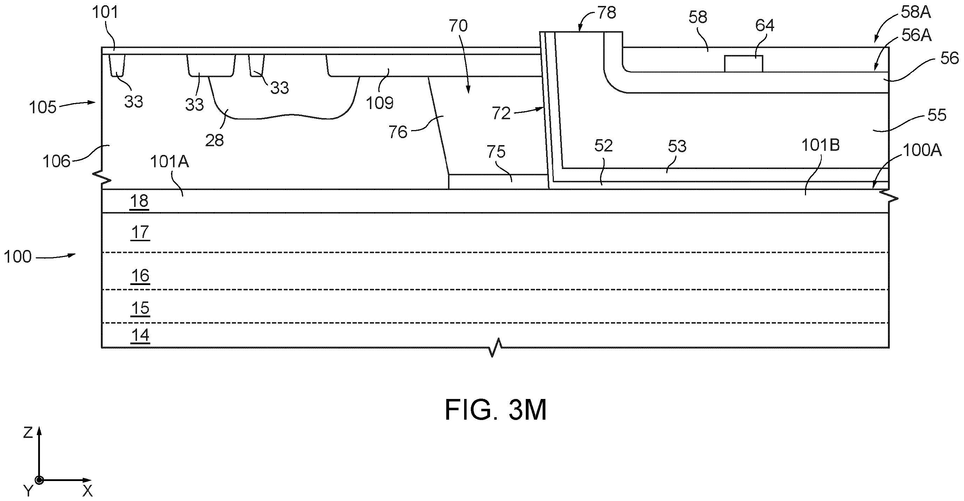

Then, Figure 3M, the wafer 100 is etched so as to remove the etching mask 111 and thus expose the gate layer 110.

In this embodiment, the etching of the etching mask 111 also etches the protective layer 118, thus reducing its thickness. However, since the thickness of the etching mask 111 is smaller than the distance between the upper surface 64 of the channel modulation region 64 and the upper surface 118A of the protective layer 118, the remaining protective layer 118 still completely covers the channel modulation region 64. Consequently, the channel modulation region 64 cannot be damaged by the etching of Figure 3M.

Following upon the etching, the protective layer 118 forms the insulating layer 58 described with reference to Figure 1.

According to the materials forming the etching mask 111 and the protective layer 118 and to the specific etching used to remove the etching mask 111, the etching of Figure 3M may selectively remove only the etching mask 111 and not the protective layer 118.

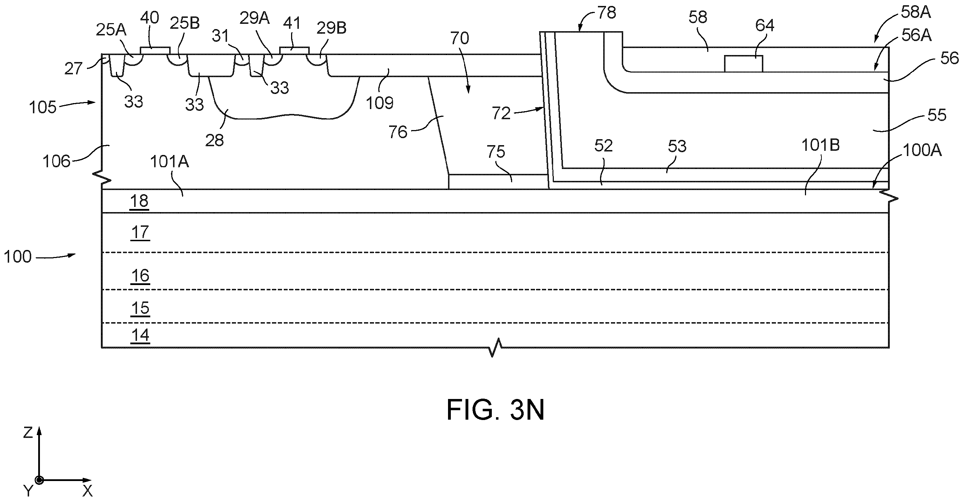

Subsequently, Figure 3N, the gate layer 110 is defined, thereby forming the gate insulated regions 40, 41. Furthermore, the (highly) doped regions 25A, 25B, 27, 29A, 29B, 31 are formed within the epitaxial portion 106 of the surface layer 105; for example, they may be defined through subsequent operations of masking and ion implantation.

Manufacturing steps follow, here not shown, for forming insulation and/or passivation layers of the wafer 100 (for example the oxide layers 35, 36 of Figure 1) and forming the metal contact regions (for example the regions 42-45 and 61, 62, 65 of Figure 1) of the electronic components 5, 7.

Furthermore, final manufacturing steps follow, here not shown, such as for example forming upper layers of metal interconnection and dicing the wafer, which lead to the formation of the device 1.

In practice, in the present manufacturing process, at least part of the doped regions 25A, 25B, 27, 28, 29A, 29B, 31 of the silicon-based components 5 (here the PMOS 5A, NMOS 5B transistors) is formed after growing the epitaxial multilayer 49.

In particular, the high-doping doped regions of the silicon-based components 5, i.e. here the source 25A, 29A and drain 25B, 29B regions, and the body contact regions 27, 31 of the transistors 5A, 5B, are formed after growing the epitaxial multilayer 49.

This allows the epitaxial multilayer 49, 114 to be grown using a high thermal budget that allows to obtain a good quality of growth of the epitaxial multilayer 49 and, at the same time, to not affect negatively the manufacturing of the silicon-based components 5.

For example, in fact, the growth of the first buffer layer 52 of AlN may occur at a temperature of about 1100°C for a time interval comprised between about 15 and 30 minutes, and the growth of the GaN and AlGaN layers that form the second buffer layer 53, the channel layer 55, the barrier layer 56 and the channel modulation region 64 may occur in subsequent growth steps, each at a temperature of about 1030°C-1080°C for an interval of about 5-15 minutes. This thermal budget would cause diffusion of the doping atoms of the high-doping regions of the transistors 5A, 5B, and therefore a low reliability of the manufacturing process.

Conversely, the present manufacturing process allows both silicon-based electronic components 5 and heterostructure-based electronic components 7 to be integrated in a same die and, at the same time, both a high crystallographic quality of the heterostructure 50 and a high manufacture reliability of the silicon-based components 5 to be obtained. As a result, the silicon-based components 5 and the heterostructure-based components 7 may have high electrical performances, in use.

Furthermore, in the embodiment shown, wherein the silicon-based components 5 include the MOS transistors 5A, 5B, the fact that the work multilayer 114 may be grown after the formation of the gate insulated layer 110 and before the definition of the gate insulated layer 110, allows to simplify the manufacturing steps related to the formation of the epitaxial multilayer 49.

In fact, for example, the gate insulated layer 110 may be used as a support for the formation of the etching mask 111.

Furthermore, still with reference to the embodiment of the manufacturing process of Figures 3A-3N, the use of the growth mask 103 may allow at the same time both to grow the epitaxial portion 106, monocrystalline, wherein the silicon-based electronic components 5 are formed, and to safeguard the surface quality of the upper surface 100A below the growth mask 103, whereon the work multilayer 114 is grown.

The fact that the growth mask 103 may comprise an oxide, in particular silicon oxide, causes the growth mask 103 to be etchable through chemical species different from those usable to remove the second intermediate layer 18. Consequently, the opening or recess 113 through the sacrificial portion 107, which exposes the underlying upper surface 100A, may be formed without affecting, at least to a first approximation, the quality of the surface 100A on which to grow the work epitaxial multilayer 114 (Figures 3G-3I) .

In particular, the fact that the growth mask 103 comprises a layer comprising oxide in direct contact with the semiconductor layer 18 may allow the risk of damaging the surface 100A on which to grow the epitaxial multilayer 49 to be further reduced.

In particular, the fact that the growth mask 103 is of silicon oxide and the layer 18 of silicon allows to obtain a highly selective etch rate of the growth mask 103 with respect to the silicon of the layer 18. Furthermore, a wet-type etching may also be used to clean the surface 100A before the growth of the work epitaxial multilayer 114.

In practice, the growth mask 103 may be used as a stop layer during the etching of the overlying sacrificial portion 107, thus ensuring complete removal of the overlying sacrificial portion 107. Furthermore, the formation of the opening in the growth mask 103 does not affect the quality, for example in terms of terracing and pitting, of the underlying surface 100A.

The epitaxial multilayer 49, and therefore the heterostructure 50, may have a high crystallographic quality. Consequently, the corresponding electronic components 7, whose functioning is based on the formation of the two-dimensional gas in the heterostructure 50, may have high electrical performances, in use.

At the same time, the electronic components 5 are also integrated in a monocrystalline silicon layer (epitaxial portion 106) which may have a high crystallographic quality. Consequently, the electronic components 5 may have high electrical performances, in use.

Furthermore, the thickness of the growth mask 103 may be sufficiently thick to be used as a mask for forming the epitaxial multilayer 49 and, at the same time, sufficiently thin to minimize the non-planarity of the upper surface 105A of the surface layer 105. In practice, the upper surface 105A of the surface layer 105 may be considered substantially planar. This allows the subsequent manufacturing steps, which lead to the formation of both the silicon-based electronic components 5 and the heterostructure-based electronic components 7, to be facilitated.

The possibility of using the substrate 14 of <111> silicon as a starting substrate for forming the semiconductor electronic device 1 may allow a high epitaxial quality of the heterostructure 50 to be obtained, in particular when the channel layer 55 is of GaN. Consequently, the heterostructure-based electronic components 7 may have excellent electrical performances. The Applicant has also verified that the use of the substrate 14 of <111> silicon also allows excellent electrical performances of the silicon-based electronic components 5 to be obtained.

However, it will be clear to the person skilled in the art that the manufacturing steps described above and the respective order of execution may be different from what has been shown in Figures 3A-3N, according to the specific processes and machinery used.

For example, the epitaxial multilayer 49 may be grown prior to the surface layer 105.

For example, the body regions of the NMOS, PMOS transistors may be formed before forming the insulation oxide (33, 108) or implanted after forming the field insulation (STI); in particular, they are formed before forming the oxide forming the gate structure of the PMOS, NMOS transistors, i.e. for example before depositing the polysilicon layer 110.

For example, the multilayer 114 may selectively grow only from the exposed portion 101B. In this case, the portion 115 would not be present; consequently, the removal of Figure 3L may be absent.

Finally, it is clear that other modifications and variations may be made to the electronic device 1 and the manufacturing process thereof described and illustrated herein, without thereby departing from the scope of the present invention, as defined in the attached claims.

The electronic device 1 may comprise, additionally or alternatively to the PMOS 5A and NMOS 5B transistors, other silicon-based electronic components 5, active and/or passive, integrated into the die 3.

For example, as shown in Figure 2, the silicon-based electronic components 5 may also include bipolar transistors 5C and passive components 5D such as diodes and resistors. In Figure 2, the bipolar transistors 5C and the passive components 5D are integrated in respective device portions 120, 121 distinct from each other and indicated schematically by a dashed line.

For example, the device portions 120, 121 are formed in respective monocrystalline silicon epitaxial regions grown on the substrate region 10, in particular monolithic with the epitaxial region 23.

Insulation regions, for example shallow or deep trenches, may be arranged, in a per se know manner, between the portions 120, 121 and 20, so that the respective electronic components are, in use, electrically insulated from each other.

The device 1 may also comprise other silicon-based electronic components 5 integrated into the die 3, in addition to or in lieu of those shown in Figure 2. For example, the components 5 may include MOS transistors for medium voltage applications, for example from 15 V to 20 V; DMOS transistors and/or drift MOS transistors, for example for applications at operating voltages from 20V to 200V; thin film resistors; OTP or MTP memories; phase change memories; etc.

It will be clear to the person skilled in the art that the integration of silicon-based electronic components 5 of types different from each other may be performed through manufacturing steps which are per se known and therefore not further shown here, for example through BCD technology.

For example, the conductivity type, n or p, of the various semiconductive regions may be inverted with respect to what has been described.

For example, the epitaxial multilayer 49 may comprise only the heterostructure 50. In other words, the heterostructure 50 may be grown directly on the substrate region 10.

For example, the layers 14-18 may comprise one or more diffused regions of doping species (P or N) according to the specific application.

For example, the heterostructure-based components 7 may include electronic components other than the HEMT transistor 7.

For example, the HEMT transistor 7 may be of normally-off type, wherein the gate structure may be different from what has been previously described; for example, the gate structure may be of recess type and/or the manufacture of the gate structure may include the use of fluorine plasma under the gate structure. Alternatively, the HEMT transistor 7 may be of normally-on type, i.e. of the depletion type.

For example, with reference to Figure 1, the insulation region 77 which extends between the first and the second device portions 20, 21 may have different shape and structure from what has been shown. For example, it may be one or more trenches extending along the third axis Z to a greater depth in the die 3.

For example, the number of epitaxial layers which form the substrate region 10 may be different, according to the specific application.

For example, as a function of the desired thicknesses, along the third axis Z, of the epitaxial multilayer 49 and of the epitaxial region 23, the second intermediate layer 18 may be absent and the epitaxial multilayer 49 may be grown directly on the second deep layer 17.

In case of medium or low voltage applications (for example from 7 V to 40 V) the substrate region 10 may comprise only the substrate 14 and the first deep layer 15 (or also the first intermediate layer 16). In practice, in this case, the epitaxial multilayer 49 may be grown directly on the first deep layer 15 or, if any, on the first intermediate layer 16.

For example, the electronic components 5 may be electronic components based on a single semiconductor other than silicon, for example Ge, SiGe, etc.

## Claims

1. A process for manufacturing a semiconductor electronic device (1), comprising:
providing a wafer (100) comprising a substrate layer (18) of semiconductor material having a first portion (101A) and a second portion (101B) distinct from the first portion;
growing an epitaxial region (23, 106) of a single semiconductor material on the first portion (101A) of the substrate layer;
growing, on the second portion (101B) of the substrate layer, an epitaxial multilayer (49, 114) comprising a heterostructure (50);
forming a first electronic component (5A, 5B, 5C, 5D) based on the single semiconductor material, from the epitaxial region (23, 106); and
forming a second electronic component (7) based on heterostructure, from the heterostructure,
wherein forming a first electronic component comprises forming a plurality of doped regions (25A, 25B, 27, 29A, 29B, 31) in the epitaxial region (23), after the step of growing an epitaxial multilayer.

2. The manufacturing process according to the preceding claim, wherein the first electronic component is a MOS transistor (5A, 5B) and forming a plurality of doped regions includes forming, in the epitaxial region, one or more of: source region (25A, 29A), drain region (25B, 29B) and body contact region (27, 31) of the MOS transistor.

3. The manufacturing process according to claim 1 or 2, wherein the first electronic component is a MOS transistor (5A, 5B) having a gate insulated region (40, 41), forming a first electronic component further comprising:
forming a gate insulated layer (110), for example of polysilicon, on the epitaxial region (106), before growing the epitaxial multilayer (114, 49); and
defining the gate insulated layer, after the step of growing the epitaxial multilayer, thus forming the gate insulated region.

4. The manufacturing process according to any of the preceding claims, wherein the doped regions have a doping level comprised between 1·10¹⁶ atoms/cm³ and 4·10²¹ atoms/cm³.

5. The manufacturing process according to any of the preceding claims, wherein growing an epitaxial multilayer comprises:
forming a growth mask (103) on the substrate layer (18); and
forming an opening in the growth mask (103), thus exposing the second portion of the substrate layer.

6. The manufacturing process according to the preceding claim, wherein the growth mask (103) is formed before growing the epitaxial region, the growth mask exposing the first portion (101A) of the substrate layer (18).

7. The manufacturing process according to claim 5 or 6, wherein growing the epitaxial region comprises growing a surface layer (105) of the single semiconductor material having a first portion (106) extending on the first portion (101A) of the substrate layer (18) and a second portion (107) extending on the growth mask (103); and wherein forming an opening in the growth mask (103) comprises forming, in the second portion (107) of the surface layer, a recess extending up to the growth mask.

8. The manufacturing process according to the preceding claim, further comprising forming an etching mask (111) extending over the first portion (106) of the surface layer (105) and having an opening (113) over the second portion (107) of the surface layer (105),
wherein growing an epitaxial multilayer comprises: growing a work multilayer (114) having a first portion (116) extending on the second portion (101B) of the substrate layer (18) and a second portion (115) extending on the etching mask; and removing the second portion (115) of the work multilayer,
wherein the etching mask (111) extends along a direction (Z) from a surface (110A) that is arranged at a height, from the substrate layer (18) along the direction (Z), that is higher with respect to the first portion (116) of the work multilayer.

9. The manufacturing process according to any of claims 5-8, wherein the growth mask (103) comprises an oxide layer, for example silicon oxide.

10. The manufacturing process according to any of claims 5-9, wherein the growth mask (103) has a thickness comprised between 7 nm and 300 nm.

11. The manufacturing process according to any of the preceding claims, wherein the second electronic component is a HEMT transistor (7), wherein the heterostructure is based on materials of groups III and V of the periodic table, for example comprising GaN.

12. The manufacturing process according to the preceding claim when dependent on claim 3, wherein the HEMT transistor comprises a channel modulation region (64) of semiconductor material having an upper surface (64A), forming a second electronic component comprising growing the channel modulation region on the heterostructure (50) so that the upper surface (64A) of the channel modulation region (64) is arranged at a distance, from the substrate layer (18) along a direction (Z), that is lower than the distance along the direction (Z) between an upper surface (110A) of the gate insulated layer (110) and the substrate layer.

13. The manufacturing process according to any of the preceding claims, wherein the wafer comprises a substrate (14) having a first conductivity type (P), the substrate layer (15, 16, 17, 18) having a second conductivity type (N) different from the first conductivity type and extending over the substrate.

14. The manufacturing process according to any of the preceding claims, wherein the single semiconductor material is silicon, and the wafer (100) is of monocrystalline silicon, in particular <111> silicon.

15. A semiconductor electronic device (1) comprising:
a die (3);
a first electronic component (5) based on a single semiconductor material; and
a second electronic component (7) based on heterostructure,
wherein the die comprises:
a substrate region (10) of semiconductor material;
a first surface portion (20) comprising a monocrystalline region (23) of the single semiconductor material extending on the substrate region; and
a second surface portion (21) distinct from the first surface portion and comprising an epitaxial multilayer (49) extending on the substrate region, the epitaxial multilayer comprising a heterostructure (50),
the first electronic component (5) being integrated into the first surface portion of the die and the second electronic component (7) being integrated into the second surface portion of the die.
